# EUROPÄISCHE PATENTANMELDUNG

(11) **EP 2 405 480 A2**
(43) Veröffentlichungstag der Anmeldung: **11.01.2012**
(21) Anmeldenummer: 11163095.0
(22) Anmeldetag: 20.04.2011
(51) Int. Cl.: H01L 23/373

(54) **Kühlkörper mit einem elektrischen Bauteil**

(30) Priorität: 08.07.2010 DE 102010026529
(71) Anmelder: Converteam GmbH, 12277 Berlin (DE)
(72) Erfinder: Möhlenkamp, Georg, 14979, Großbeeren (DE); Keller, Christian, 14169, Berlin (DE)
(74) Vertreter: Dreiss

(57) **Zusammenfassung**

Es wird ein Kühlkörper (10) mit einem elektrischen Bauteil (11) beschrieben, wobei der Kühlkörper (10) mehrere Kühlrippen (14) aufweist, und wobei zwischen der Oberseite (12) des Kühlkörpers (10) und den Kühlrippen (14) Kohlenstoff-Nanoröhrchen vorhanden sind. Die Kohlenstoff-Nanoröhrchen erstrecken sich von der Oberseite (12) des Kühlkörpers (10) in Richtung zu einer der Kühlrippen (14) und ihre Ausrichtung weist einen Ausrichtungswinkel zu der Ausrichtung der zugeordneten Kühlrippe (14) auf.

## Beschreibung

Die Erfindung betrifft einen Kühlkörper mit einem elektrischen Bauteil sowie einen Kühlkörper für ein elektrisches Bauteil.

Aus der DE 102 48 644 A1 ist eine Anordnung bekannt, bei der ein elektrisches Leistungshalbleitermodul über Kohlenstoff-Nanoröhrchen mit einem Kühlkörper verbunden ist. Die Kohlenstoff-Nanoröhrchen sind dabei orthogonal zur Oberfläche des Kühlkörpers ausgerichtet. Die Kohlenstoff-Nanoröhrchen können beispielsweise gemäß der DE 101 03 340 A1 auf die erwünschte Oberfläche aufgebracht werden. Mit Hilfe der Kohlenstoff-Nanoröhrchen wird eine Ableitung der von dem Leistungshalbleitermodul erzeugten Wärme zu dem Kühlkörper erreicht.

Aufgabe der Erfindung ist es, bei der bekannten Anordnung eine verbesserte Wärmeableitung zu erreichen.

Diese Aufgabe wird durch einen Kühlkörper mit einem elektrischen Bauteil gemäß Anspruch 1 sowie durch einen Kühlkörper für ein elektrisches Bauteil gemäß Anspruch 8 gelöst.

Bei der Erfindung weist der Kühlkörper mehrere Kühlrippen auf und zwischen der Oberseite des Kühlkörpers und den Kühlrippen sind Kohlenstoff-Nanoröhrchen vorhanden. Diese Kohlenstoff-Nanoröhrchen erstrecken sich von der Oberseite des Kühlkörpers in Richtung zu einer der Kühlrippen und ihre Ausrichtung weist einen Ausrichtungswinkel zu der Ausrichtung der zugeordneten Kühlrippe auf.

Die Erfindung weist den Vorteil auf, dass die von der Grundfläche des elektrischen Bauteils abgegebene Wärme über die Kohlenstoff-Nanoröhrchen auf die Kühlrippen verteilt wird. Es können damit die guten wärmeleitenden Eigenschaften der Kohlstoffnanoröhrchen ausgenutzt werden. Dies ermöglicht es, dass mit Hilfe der Erfindung mehr Wärme von dem elektrischen Bauteil abgeleitet werden kann. Die Erfindung ermöglicht also eine verbesserte Kühlung des elektrischen Bauteils. Die Verteilung der Wärme auf die Kühlrippen wird dabei von dem Ausrichtungswinkel bestimmt.

Der Ausrichtungswinkel kann dabei vorteilhafterweise eine Abhängigkeit vom Ort im Kühlkörper aufweisen.

Bei einer Ausgestaltung der Erfindung ist eine an dem Kühlkörper anliegende bzw. anlegbare Grundfläche des elektrischen Bauteils kleiner als die Fläche der Oberseite des Kühlkörpers. Weiterhin erstrecken sich die Kohlenstoff-Nanoröhrchen von der Oberseite des Kühlkörpers in Richtung zu mehreren Kühlrippen, wobei die Ausrichtungswinkel von Kohlenstoff-Nanoröhrchen, die unterschiedlichen Kühlrippen zugeordnet sind, unterschiedlich sind. Die Kohlenstoff-Nanoröhrchen sind also in unterschiedliche Richtungen ausgerichtet. Die Wärme wird somit ausgehend von der kleinen Grundfläche "gespreizt bzw. aufgefächert". Dies bringt den Vorteil mit sich, dass die Wärme des elektrischen Bauteils nahezu beliebig zu den Kühlrippen des Kühlkörpers abgeleitet und verteilt werden kann. Die Ausrichtungswinkel können dabei vorzugsweise derart gewählt werden, dass für die abzuleitende Wärme ein möglichst geringer Wärmewiderstand entsteht.

Bei einer weiteren Ausgestaltung der Erfindung ist den Kühlrippen jeweils ein plattenartiger Bereich zugeordnet, in denen gleichartig ausgerichtete Kohlenstoff-Nanoröhrchen vorhanden sind. Damit ist es möglich, dass gleichartig ausgerichtete Kohlenstoff-Nanoröhrchen nach einem bekannten Verfahren hergestellt werden, um danach derart ausgebildet zu werden, dass sie den erwünschten plattenartigen Bereich bilden. Beispielsweise ist es möglich, dass die gleichartig ausgerichteten Kohlenstoff-Nanoröhrchen durch ein Aufwachsoder Züchtverfahren oder dergleichen hergestellt werden und dann durch ein Schneidverfahren oder dergleichen die erwünschten plattenartigen Bereiche hergestellt werden.

Besonders vorteilhaft ist es, wenn der plattenartige Bereich etwa trapezartig ausgebildet ist, an seiner Oberseite eine Länge besitzt, die etwa der Länge des elektrischen Bauteils entspricht, und an seiner Unterseite eine Länge besitzt, die etwa der Länge der zugehörigen Kühlrippe entspricht. Auf diese Weise ist es möglich, die Wärme über die gesamte Längsseite der zugehörigen Kühlrippe zu verteilen.

Weiterhin ist es vorteilhaft, wenn in den Kühlrippen Kohlenstoff-Nanoröhrchen vorhanden sind, die in Richtung zu dem freien Ende der jeweiligen Kühlrippe und/oder schräg und/oder quer dazu ausgerichtet sind. Damit ist es möglich, die Wärme mit Hilfe der Kohlenstoff-Nanoröhrchen innerhalb der Kühlrippen zu verteilen und dort zur Kühlrippen-Oberfläche zu transportieren.

Eine besonders vorteilhafte Ausgestaltung der Erfindung besteht darin, dass die Kohlenstoff-Nanoröhrchen in einem Trägermaterial eingebettet sind. Die beispielsweise mittels Schneidverfahren hergestellten Bereiche gleichartig ausgerichteter Kohlenstoff-Nanoröhrchen können damit beliebig innerhalb des Kühlkörpers angeordnet und dann mit Hilfe des Trägermaterials örtlich fixiert werden. Gegebenenfalls kann somit der gesamte Kühlkörper aus dem Trägermaterial und darin eingebetteten Kohlenstoff-Nanoröhrchen aufgebaut werden. Dies bringt nicht nur Vorteile im Hinblick auf die Herstellung des Kühlkörpers mit sich, sondern auch im Hinblick auf dessen Masse und Kosten. Weiterhin weist der Kühlkörper aufgrund des Trägermaterials gegebenenfalls ohne weitere Maßnahmen bereits isolierende Eigenschaften auf.

Weitere Merkmale, Anwendungsmöglichkeiten und Vorteile der Erfindung ergeben sich aus der nachfolgenden Beschreibung von Ausführungsbeispielen der Erfindung, die in den Figuren der Zeichnung dargestellt sind. Dabei bilden alle beschriebenen oder dargestellten Merkmale für sich oder in beliebiger Kombination den Gegenstand der Erfindung, unabhängig von ihrer Zusammenfassung in den Patentansprüchen oder deren Rückbeziehung sowie unabhängig von ihrer Formulierung bzw. Darstellung in der Beschreibung bzw. in der Zeichnung.

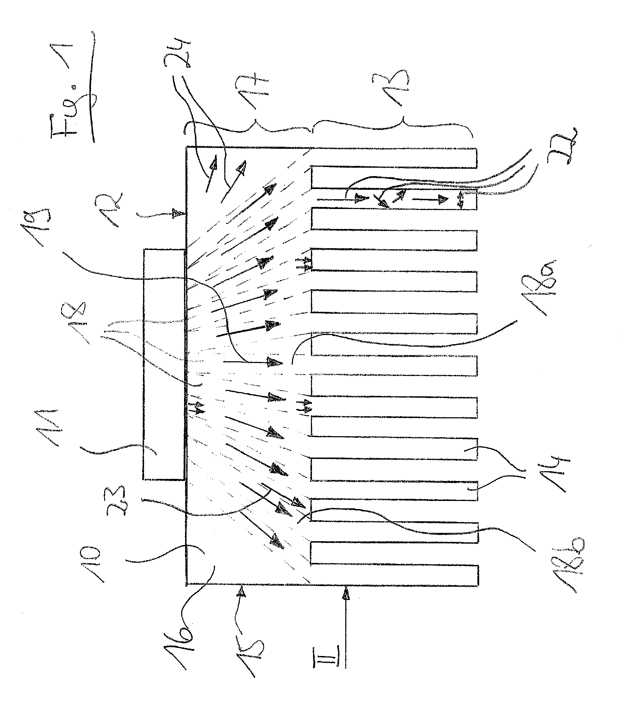

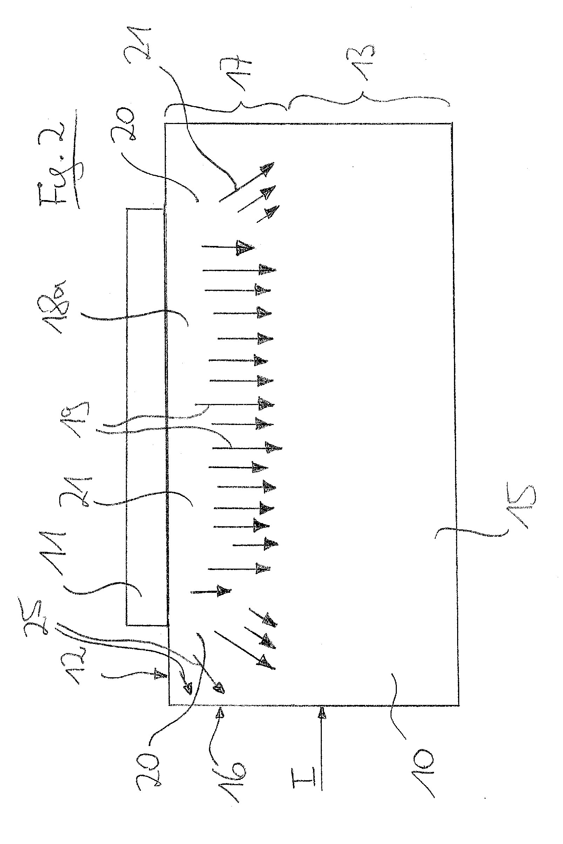

Figur 1 zeigt eine schematische Seitenansicht der Querseite eines Ausführungsbeispiels eines erfindungsgemäßen Kühlkörpers mit einem elektronischen Bauteil aus der Richtung I der Figur 2 und Figur 2 zeigt eine schematische Seitenansicht der Längsseite des Kühlkörpers mit dem elektrischen Bauteil der Figur 1 aus der Richtung II der Figur 1.

In den Figuren 1 und 2 ist ein Kühlkörper 10 mit einem vorzugsweise elektrischen Bauteil 11 dargestellt. Bei dem elektrischen Bauteil 11 kann es sich um jegliches Bauteil handeln, das in seinem Betrieb Wärme erzeugt. Beispielsweise kann es sich bei dem elektrischen Bauteil um eine Diode, einen Transistor, einen Thyristor, einen IGBT (IGBT = insulated gate bipolar transistor) oder um mehrere derartige Bauteile oder um eine Kombination derartiger Bauteile handeln.

Der Kühlkörper 10 ist im vorliegenden Ausführungsbeispiel etwa quaderförmig ausgebildet. Auf einer Oberseite 12 des Kühlkörpers 10 ist das elektrische Bauteil 11 angeordnet. Das elektrische Bauteil 11 weist dabei eine etwa rechteckige Grundfläche auf, die kleiner ist als die ebenfalls etwa rechteckige Fläche der Oberseite 12 des Kühlkörpers 10. Das elektrische Bauteil ist im vorliegenden Ausführungsbeispiel etwa mittig auf dem Kühlkörper 10 angeordnet. Das elektrische Bauteil 11 liegt möglichst ganzflächig auf der Oberseite 12 des Kühlkörpers 10 an. Gegebenenfalls kann zwischen dem elektrischen Bauteil 11 und dem Kühlkörper 10 ein Wärmeleitmittel oder dergleichen vorhanden sein.

Weiterhin weist der Kühlkörper 10 einen von der Oberseite 12 abgewandten Endbereich 13 auf, in dem eine Mehrzahl von Kühlrippen 14 vorhanden sind. Die Kühlrippen 14 sind etwa parallel zueinander ausgerichtet und verlaufen parallel zu einer Längsseite 15 des Kühlkörpers 10. Im Hinblick auf eine Querseite 16 des Kühlkörpers 10 sind die Kühlrippen 14 mit Abstand nebeneinander angeordnet. Hinsichtlich der Oberseite 12 des Kühlkörpers 10 stehen die Kühlrippen 14 etwa lotrecht von dem Kühlkörper 10 ab.

Zwischen der Oberseite 12 und dem Endbereich 13 weist der Kühlkörper 10 einen Übergangsbereich 17 auf. In der Figur 1 ist der Übergangsbereich 17 mit Blick auf die Querseite 16 des Kühlkörpers 10 gezeigt und in der Figur 2 mit Blick auf die Längsseite 15. Der Übergangsbereich 17 ist etwa quaderförmig ausgebildet.

In dem Übergangsbereich 17 sind mehrere plattenartige Bereiche 18 enthalten. Im vorliegenden Ausführungsbeispiel entspricht die Anzahl der plattenartigen Bereiche 18 der Anzahl der Kühlrippen 14. Jeder Kühlrippe 14 ist dabei einer der plattenartigen Bereiche 18 zugeordnet. Die plattenartigen Bereiche 18 erstrecken sich von der Oberseite 12 des Kühlkörpers 10 durch den Übergangsbereich 17 hindurch zu dem Endbereich 13 und damit den Kühlrippen 14 des Kühlkörpers 10.

Im vorliegenden Ausführungsbeispiel verläuft einer der plattenartigen Bereiche 18 parallel zu der zugehörigen Kühlrippe 14. Dieser plattenartige Bereich ist in der Figur 1 mit dem Bezugszeichen 18a gekennzeichnet. Weiterhin ist dieser plattenartige Bereich 18a in der Figur 2 gezeigt.

Gemäß der Figur 2 weist der plattenartige Bereich 18a eine etwa trapezartige Gestalt auf. An seiner Oberseite besitzt er eine Länge, die etwa der Länge des elektrischen Bauteils 11 entspricht. An seiner Unterseite besitzt er eine Länge, die etwa der Länge der zugehörigen Kühlrippe 14 entspricht. Die Länge an der Oberseite ist kleiner als die Länge an der Unterseite. Gemäß der Figur 1 weist der plattenartige Bereich 18a in seiner Querrichtung eine Dicke auf, die etwa der Dicke der zugehörigen Kühlrippe 14 entspricht. Im vorliegenden Ausführungsbeispiel ist diese Dicke derart vorgesehen, dass die Dicken aller plattenförmigen Bereiche 18 zusammen etwa der Länge des elektrischen Bauteils 11 in Querrichtung entsprechen.

Der plattenartige Bereich 18a besteht im Wesentlichen aus einem Trägermaterial, in dem Kohlenstoff-Nanoröhrchen eingebettet sind, wie sie beispielsweise aus der DE 102 48 644 A1 oder der DE 101 03 340 A1 bekannt sind. Bei dem Trägermaterial kann es sich beispielsweise um einen Kunststoff handeln. Die Kohlenstoff-Nanoröhrchen sind in diejenige Richtung ausgerichtet, die in den Figuren 1 und 2 innerhalb des plattenartigen Bereichs 18a durch einen Pfeil 19 angegeben ist.

Abgesehen von zwei Randbereichen 20 sind die Kohlenstoff-Nanoröhrchen in dem dazwischenliegenden Bereich 21 des plattenartigen Bereichs 18a in eine Richtung ausgerichtet, die von der Oberseite 12 des Kühlkörpers 10 zu dessen Endbereich 13 und damit zu den Kühlrippen 14 zeigt. Im Hinblick auf die Figur 1 wird für die nachfolgenden Erläuterungen ein Ausrichtungswinkel für die Kohlenstoff-Nanoröhrchen festgelegt, der dem Winkel zwischen der Ausrichtung der Kohlenstoff-Nanoröhrchen und der Ausrichtung der Kühlrippen 14 vorhanden ist. In dem plattenartigen Bereich 18a ist der Ausrichtungswinkel damit 0 bzw. 180 Grad.

In den beiden Randbereichen 20 des plattenartigen Bereichs 18a sind die Kohlenstoff-Nanoröhrchen in eine Richtung ausgerichtet, die jeweils einen Winkel zu den zuvor erläuterten Kohlenstoff-Nanoröhrchen aufweist und damit schräg zur jeweiligen Querseite 16 des Kühlkörpers 10 zeigt. Dies ist in der Figur 2 durch die Pfeile 21 kenntlich gemacht.

Ein anderer, beispielhaft herausgegriffener plattenartiger Bereich 18 ist in der Figur 1 mit dem Bezugszeichen 18b gekennzeichnet. Dieser plattenartige Bereich 18b ist im Wesentlichen gleichartig ausgebildet wie der plattenartige Bereich 18a. Ein Unterschied besteht jedoch darin, dass der plattenartige Bereich 18b nicht parallel zu der zugehörigen Kühlrippe 14 ausgebildet ist, sondern einen Winkel dazu aufweist. Der plattenartige Bereich 18b ist somit innerhalb des Übergangsbereichs 17 schräg oder leicht geneigt angeordnet. Der Ausrichtungswinkel der Kohlenstoff-Nanoröhrchen in dem plattenartigen Bereich 18b ist damit beispielhaft etwa 45 Grad.

Der Ausrichtungswinkel, mit dem unterschiedliche plattenartige Bereiche 18 im Hinblick auf die jeweils zugehörige Kühlrippe 14 angeordnet sind, ist ebenfalls unterschiedlich. Je weiter der jeweilige plattenartige Bereich 18b außermittig angeordnet ist, desto größer ist die Neigung des plattenartigen Bereichs 18b im Hinblick auf die Ausrichtung der zugeordneten Kühlrippe 14. Wie bereits erwähnt, weist nur der etwa mittig angeordnete plattenartige Bereich 18a etwa dieselbe Ausrichtung auf wie die zugehörige Kühlrippe 14.

Es wird darauf hingewiesen, dass die Einführung und Erläuterung der verschiedenen Bereiche nur dazu dient, den Aufbau des Kühlkörpers 10 verständlich darzustellen. Letztlich sind es nur die Kohlenstoff-Nanoröhrchen, die in dem Trägermaterial des Kühlkörpers 10 entsprechend ausgerichtet sind. Die erläuterten Bereiche sind unter Umständen als solche nicht erkennbar bzw. deren Übergänge sind gar nicht vorhanden. In diesem Fall sind also nur die entsprechend ausgerichteten Kohlenstoff-Nanoröhrchen in dem Trägermaterial vorhanden.

Wie bereits erwähnt, erstrecken sich die plattenartigen Bereiche 18 von dem elektrischen Bauteil 11 zu den Kühlrippen 14 des Kühlkörpers 10. Wie sich auch aus den Figuren 1 und 2 ergibt, bilden die Oberseiten aller plattenartigen Bereiche 18 eine Fläche, die etwa der Grundfläche des elektrischen Bauteils 11 entspricht. Die von dem elektrischen Bauteil 11 erzeugte und an den Kühlkörper 10 abgegebene Wärme geht damit von der dem Kühlkörper 10 zugewandten Grundfläche des elektrischen Bauteils 11 über die Oberseiten aller plattenartigen Bereiche 18 auf die in den plattenartigen Bereichen 18 enthaltenen Kohlenstoff-Nanoröhrchen über. Mit Hilfe der entsprechend ausgerichteten Kohlenstoff-Nanoröhrchen wird die Wärme dann zu den Kühlrippen 14 des Kühlkörpers 10 weitergeleitet.

Das elektrische Bauteil 11 kann dabei sogenannte Heißbereiche aufweisen. Dies bedeutet, dass einzelne Bereiche der Grundfläche des elektrischen Bauteils 11 heißer sind als andere Bereiche der Grundfläche. In diesem Fall können die plattenartigen Bereiche 18 des Kühlkörpers 10 nicht, wie erläutert, gleichartig über die Grundfläche des elektrischen Bauteils 11 verteilt sein, sondern sie können in einem Heißbereich enger ausgebildet sein als außerhalb eines Heißbereichs. Es kann also auch eine nichtlineare Verteilung der plattenartigen Bereiche 18 auf die Grundfläche des elektrischen Bauteils 11 vorgesehen sein.

Mit Hilfe der entsprechend ausgerichteten Kohlenstoff-Nanoröhrchen wird erreicht, dass die von dem elektrischen Bauteil 11 an den Kühlkörper 10 abgegebene Wärme sich nicht diffus innerhalb des Kühlkörpers 10 ausbreitet, sondern dass die Wärme über die plattenartigen Bereiche 18 und die darin enthaltenen Kohlenstoff-Nanoröhrchen gezielt zu den Kühlrippen 14 des Kühlkörpers 10 geführt wird.

Dies wird dadurch erreicht, dass die Kohlenstoff-Nanoröhrchen innerhalb der plattenartigen Bereiche 18 in Richtung zu einer der Kühlrippen 14 des Kühlkörpers 10 ausgerichtet sind. Insbesondere wird dies dadurch erreicht, dass jeder der plattenartigen Bereiche 18 einer bestimmten Kühlrippe 14 zugeordnet und in deren Richtung ausgerichtet ist. Jede der einzelnen Kühlrippen 14 ist damit einem Teil der Grundfläche des elektrischen Bauteils 11 zugeordnet und die von diesem Teil der Grundfläche abgegebene Wärme des elektrischen Bauteils 11 wird dann über die Kohlstoffnanoröhrchen des zugehörigen plattenartigen Bereichs 18 der ebenfalls zugehörigen Kühlrippe 14 zugeleitet.

In den beiden Randbereichen 20 der plattenartigen Bereiche 18 wird durch die schräge Ausrichtung der Kohlenstoff-Nanoröhrchen erreicht, dass die Wärme innerhalb der jeweiligen Kühlrippe 14 über die gesamte Längsseite 15 des Kühlkörpers 10 verteilt wird.

Die Kohlenstoff-Nanoröhrchen können, wie bereits erwähnt, beispielsweise mit Hilfe eines Verfahrens gemäß der DE 101 03 340 A1 aufgebaut werden. Derart erstellte Kohlenstoff-Nanoröhrchen sind dann alle in dieselbe Richtung ausgerichtet. Aus derart hergestellten Kohlenstoff-Nanoröhrchen können dann diejenigen Bereiche ausgeschnitten werden, die notwendig sind, um die plattenartigen Bereiche 18 oder die Randbereiche 20 zu bilden. So können bei dem beispielhaft in der Figur 2 gezeigten plattenartigen Bereich 18a die beiden Randbereiche 20 und der dazwischenliegende Bereich 21 separat aus den hergestellten Kohlenstoff-Nanoröhrchen ausgeschnitten und danach auf irgend eine Weise zusammengefügt werden, so dass insgesamt der plattenartige Bereich 18a entsteht. Entsprechendes gilt natürlich für alle plattenartigen Bereiche 18. Alternativ ist es möglich, die Kohlenstoff-Nanoröhrchen bereits derart aufzubauen, dass die erwünschten plattenartigen Bereiche 18 gebildet werden.

Beispielsweise ist es möglich, dass die Kohlenstoff-Nanoröhrchen der plattenartigen Bereiche 18 in das Trägermaterial eingegossen und auf diese Weise innerhalb des Kühlkörpers 10 angeordnet werden. Es ist also möglich, dass zumindest der Übergangsbereich 17 des Kühlkörpers 10 aus dem Trägermaterial besteht und die plattenartigen Bereiche 18 in dieses Trägermaterial eingebracht sind.

Alternativ ist es möglich, dass die plattenartigen Bereiche 18 mit Hilfe eines oder mehrerer Rahmen zusammengehalten werden. So kann an der Oberseite und der Unterseite der plattenartigen Bereiche 18 jeweils ein Rahmen vorhanden sein, der die plattenartigen Bereiche 18 dort fixiert. Mit diesen Rahmen können die plattenartigen Bereiche 18 und damit die Kohlenstoff-Nanoröhrchen mit dem elektrischen Bauteil 11 und den Kühlrippen 14 des Kühlkörpers 10 verbunden sein.

Eine weitere Möglichkeit besteht darin, dass die plattenartigen Bereiche 18, wie bereits erwähnt wurde, als solche gar nicht vorhanden sind, sondern dass der Kühlkörper 10 als Ganzes aus dem Trägermaterial aufgebaut wird und die Kohlenstoff-Nanoröhrchen auf irgend eine Art und Weise innerhalb des Trägermaterials in die erwünschte Richtung ausgerichtet werden. Zur Ausrichtung der Kohlenstoff-Nanoröhrchen können dabei jegliche Verfahren verwendet werden, beispielsweise irgendwelche Züchtungsverfahren oder irgendwelche elektromagnetische Verfahren oder dergleichen.

Zusätzlich ist es möglich, dass auch in anderen Bereichen des Kühlkörpers 10 weitere Bereiche mit Kohlenstoff-Nanoröhrchen vorhanden sind.

So ist es beispielsweise möglich, dass die Kühlrippen 14 teilweise oder vollständig aus Kohlenstoff-Nanoröhrchen aufgebaut sind. Die Kohlenstoff-Nanoröhrchen sind dabei insbesondere in eine oder mehrere derjenigen Richtungen ausgerichtet, wie dies beispielhaft in der Figur 1 bei einer der Kühlrippen 14 mit Hilfe der Pfeile 22 dargestellt ist. Mit diesen Kohlenstoff-Nanoröhrchen wird die von dem jeweils zugehörigen plattenartigen Bereich 18 kommende Wärme innerhalb der zugeordneten Kühlrippe 14 weitergeleitet, und zwar in Richtung zu dem freien Ende der Kühlrippe 14 und/oder schräg und/oder quer zu dieser Richtung. Die Wärme wird auf diese Weise über die Kohlenstoff-Nanoröhrchen zu der gesamten Oberfläche der jeweiligen Kühlrippe 14 geführt.

Weiterhin ist es möglich, dass zwischen den plattenartigen Bereichen 18 sowie auch außerhalb der plattenartigen Bereiche 18 weitere Bereiche mit Kohlenstoff-Nanoröhrchen vorhanden sind. Dies ist in den Figuren 1 und 2 beispielhaft mit Hilfe der Pfeile 23, 24, 25 dargestellt. Mit Hilfe dieser Kohlenstoff-Nanoröhrchen wird Wärme zu den zwischen den Kühlrippen 14 vorhandenen Oberflächen des Kühlkörpers 10 sowie zu Außenflächen des Kühlkörpers 10 geführt.

Diejenigen Bereiche zwischen den plattenartigen Bereichen 18, in denen in der Figur 1 die Ausrichtung der Kohlenstoff-Nanoröhrchen mit Hilfe des Pfeils 23 dargestellt ist, können dabei auch den plattenartigen Bereichen 18 selbst zugeordnet werden. So ist es möglich, beispielsweise den plattenartigen Bereich 18a jeweils nach links und rechts zu erweitern und damit die angrenzenden dazwischenliegenden Bereiche jeweils hälftig in den plattenartigen Bereich 18a mit einzubeziehen.

Insgesamt können somit innerhalb des gesamten Kühlkörpers 10 Bereiche mit Kohlenstoff-Nanoröhrchen vorhanden sein, die jeweils in bestimmte Richtungen ausgerichtet sind. Die Kohlenstoff-Nanoröhrchen können dabei in das Trägermaterial eingebettet und auf diese Weise innerhalb des Kühlkörpers 10 fixiert sein. Der gesamte Kühlkörper 10 kann somit aus dem Trägermaterial aufgebaut und mit Kohlenstoff-Nanoröhrchen versehen sein. Mit Hilfe der Kohlenstoff-Nanoröhrchen wird die von dem elektrischen Bauteil 11 erzeugte Wärme zu den Kühlrippen 14 des Kühlkörpers 10 und gegebenenfalls zu den Oberflächen dieser Kühlrippen 14 sowie gegebenenfalls auch zu sonstigen Ober- und Außenflächen des Kühlkörpers 10 transportiert.

## Patentansprüche

1. Kühlkörper (10) mit einem elektrischen Bauteil (11), wobei der Kühlkörper (10) mehrere Kühlrippen (14) aufweist, und wobei zwischen der Oberseite (12) des Kühlkörpers (10) und den Kühlrippen (14) Kohlenstoff-Nanoröhrchen vorhanden sind, **dadurch gekennzeichnet, dass** die Kohlenstoff-Nanoröhrchen sich von der Oberseite (12) des Kühlkörpers (10) in Richtung zu einer der Kühlrippen (14) erstrecken und ihre Ausrichtung einen Ausrichtungswinkel zu der Ausrichtung der zugeordneten Kühlrippe (14) aufweist (Figur 1).

2. Kühlkörper (10) mit einem elektrischen Bauteil (11) nach Anspruch 1, wobei eine an dem Kühlkörper (10) anliegende Grundfläche des elektrischen Bauteils (11) kleiner ist als die Fläche der Oberseite (12) des Kühlkörpers (10), wobei die Kohlenstoff-Nanoröhrchen sich von der Oberseite (12) des Kühlkörpers (10) in Richtung zu mehreren Kühlrippen (14) erstrecken, und wobei die Ausrichtungswinkel von Kohlenstoff-Nanoröhrchen, die unterschiedlichen Kühlrippen (14) zugeordnet sind, unterschiedlich sind (Figur 1).

3. Kühlkörper (10) mit einem elektrischen Bauteil (11) nach einem der vorstehenden Ansprüche, wobei den Kühlrippen (14) jeweils ein plattenartiger Bereich (18, 18a, 18b) zugeordnet ist, in denen gleichartig ausgerichtete Kohlenstoff-Nanoröhrchen vorhanden sind (Figur 2).

4. Kühlkörper (10) mit einem elektrischen Bauteil (11) nach Anspruch 3, wobei der plattenartige Bereich (18, 18a, 18b) etwa trapezartig ausgebildet ist, an seiner Oberseite eine Länge besitzt, die etwa der Länge des elektrischen Bauteils (11) entspricht, und an seiner Unterseite eine Länge besitzt, die etwa der Länge der zugehörigen Kühlrippe (14) entspricht.

5. Kühlkörper (10) mit einem elektrischen Bauteil (11) nach einem der Ansprüche 3 oder 4, wobei in einem Randbereich (20) des plattenartigen Bereichs (18, 18a, 18b) Kohlenstoff-Nanoröhrchen vorhanden sind, die im Hinblick auf die anderen Kohlenstoff-Nanoröhrchen des plattenartigen Bereichs (18, 18a, 18b) einen von Null verschiedenen Winkel aufweisen.

6. Kühlkörper (10) mit einem elektrischen Bauteil (11) nach einem der vorstehenden Ansprüche, wobei in den Kühlrippen (14) Kohlenstoff-Nanoröhrchen vorhanden sind, die in Richtung zu dem freien Ende der jeweiligen Kühlrippe (14) und/oder schräg und/oder quer dazu ausgerichtet sind.

7. Kühlkörper (10) mit einem elektrischen Bauteil (11) nach einem der vorstehenden Ansprüche, wobei die Kohlenstoff-Nanoröhrchen in einem Trägermaterial eingebettet sind.

8. Kühlkörper (10) für ein elektrisches Bauteil (11), wobei der Kühlkörper (10) mehrere Kühlrippen (14) aufweist, und wobei zwischen der Oberseite (12) des Kühlkörpers (10) und den Kühlrippen (14) Kohlenstoff-Nanoröhrchen vorhanden sind, **dadurch gekennzeichnet, dass** die Kohlenstoff-Nanoröhrchen sich von der Oberseite (12) des Kühlkörpers (10) in Richtung zu einer der Kühlrippen (14) erstrecken und ihre Ausrichtung einen Ausrichtungswinkel zu der Ausrichtung der zugeordneten Kühlrippe (14) aufweist (Figur 1).

9. Kühlkörper (10) für ein elektrisches Bauteil (11) nach Anspruch 8, wobei eine an dem Kühlkörper (10) anlegbare Grundfläche des elektrischen Bauteils (11) kleiner ist als die Fläche der Oberseite (12) des Kühlkörpers (10), wobei die Kohlenstoff-Nanoröhrchen sich von der Oberseite (12) des Kühlkörpers (10) in Richtung zu mehreren Kühlrippen (14) erstrecken, und wobei die Ausrichtungswinkel von Kohlenstoff-Nanoröhrchen, die unterschiedlichen Kühlrippen (14) zugeordnet sind, unterschiedlich sind (Figur 1).
